Europäisches Patentamt

European Patent Office

Office européen des brevets

(19)

(11) Publication number: **0 130 498**
**B1**

(12) **EUROPEAN PATENT SPECIFICATION**

(45) Date of publication of patent specification: **23.09.87**

(51) Int. Cl.⁴: **H 05 K 13/00**

(21) Application number: **84107153.3**

(22) Date of filing: **22.06.84**

(54) **Highly integrated universal tape bonding of semiconductor chips.**

(30) Priority: **30.06.83 US 509507**

(43) Date of publication of application:
**09.01.85 Bulletin 85/02**

(45) Publication of the grant of the patent:
**23.09.87 Bulletin 87/39**

(84) Designated Contracting States:
**DE FR GB**

(56) References cited:
**FR-A-2 379 909**
**US-A-3 709 424**
**US-A-3 737 983**
**US-A-3 761 675**
**US-A-3 793 714**

(73) Proprietor: **International Business Machines Corporation**
**Old Orchard Road**
**Armonk, N.Y. 10504 (US)**

(72) Inventor: **Marks, Robert**
**17 Scotsdale Road**
**South Burlington, VT 05401 (US)**
Inventor: **Phelps, Douglas W., Jr.**
**21 Richardson Street**
**Burlington, VT 05401 (US)**
Inventor: **Samuelsen, Sigvart J.**
**111 Edgemoor Drive**
**Burlington, VT 05401 (US)**
Inventor: **Ward, William C.**
**28 Bilodeau Court**
**Burlington, VT 05401 (US)**

(74) Representative: **Suringar, Willem Joachim**
**Intellectual Property Department IBM Nederland**
**N.V. Watsonweg 2**
**NL-1423 ND Uithoorn (NL)**

Courier Press, Leamington Spa, England.

## Description

### Background of the invention
### Field of the invention

This invention relates to the manufacture of integrated circuit devices. In particular, it relates to a method and apparatus for connecting metallic leads to a semiconductor chip.

### Prior art

In the manufacture of semiconductor devices, the connection of metallic leads to individual chips remains a significant manufacturing problem. Typically, a large number of metallic interconnections must be coupled to an individual chip about its perimeter. One technique known in the technology is tape automatic bonding (TAB) which utilizes a roll-type film cut to form an individual set of chip I/O leads. This individual set is formed by utilizing etch techniques to obtain a personalized lead pattern which conforms to a given chip terminal pattern (footprint). The etch pattern is used to create a large number of identical sets. An individual set is then introduced at the bonding station for affixation. The individual terminal ends of the leads are then coupled using thermal compression or AuSn bonding the chip. All leads are connected to the chip simultaneously and by utilizing a continuous reel transport process, system throughput is enhanced. Thus, TAB is used to facilitate very high production rates for coupling a number of identical chip I/O's to outer circuitry.

A second known technique is wire bonding which, in contrast to TAB, is labor intensive. Wire bonding is advantageous since it affords flexibility in the placement of individual wires. The bonding tools can be used irrespective of the chip footprint. This is in contrast to the inflexibility of TAB where a given footprint etched in the tape is tailored for a specific footprint of a chip. Thus, the tooling for bonding a particular chip is dedicated for that chip size and lead pattern. It has no other utilization. Wire bonding techniques while slower in overall production speed can be tailored to accommodate disparities in chip configuration. Given these two known techniques, TAB is generally applied to very high production runs relative to wire bonding.

A second disadvantage of TAB is the long lead time necessary to obtain photoprocessed and etched full tape, personalized to a specific chip configuration. Additionally, quality control problems exist in TAB systems. Such problems occur, given variations in film thickness, etching and actual bonding on a lead-by-lead basis. Additional problems arise in the storage, handling and transportation of pre-personalized foil tape.

Within the prior art, various subsystem components described individual facets of these two techniques. For example, U.S. Patent 3,698,075 and U.S. Patent 3,709,424 disclose techniques of ultrasonic bonding of a sheet of personalized lead structures to contact pads on a chip. Specifically, U.S. Patent 3,698,075 provides a sheet metal strip having a large number of identical lead frame sections which are broken away as the sheet is unwound. The strip has a number of leads configured to match bonding pads on a chip. The strip is placed on a mounting pedestal and the chip then placed face down so that the bonding pads contact the leads. Bonding takes place utilizing a needle which is ultrasonically stimulated.

U.S. Patent 3,709,424 also employs a continuous sheet having a plurality of lead structure sections which are placed over a chip mounted on a pedestal. The pattern is personalized for the lead structure of the particular chip. Bonding occurs either by the application of heat or utilizing an ultrasonic transducer contacting each bonding point.

Computer control for the placement of lead wires is disclosed in U.S. Patent 3,737,983. Specifically, the system utilizes a series of chucks which are indexed to various work stations. The work stations contain wire loading devices, an alloy station for placing semiconductor devices in a predetermined orientation on the head of one of the wire leads and a series of automatic bonding stations for connecting the base and emitter contacts of the semiconductor devices to the head of the other wire leads. The system operates under computer control having a general purpose digital computer which is programmed to monitor operation at various stations and locate any chuck which is defective so that the production process does not continue for defectively fabricated devices.

Other prior art relating to the production of semiconductor devices, and in particular, lead structures and their bonding to integrated circuit chips are found in U.S. Patents 3,395,447; 3,544,857; 3,698,074; 3,793,714; 3,846,905; 3,859,715; 3,859,718 and 4,079,509. While this prior art defines various steps, in none is there any integrated process for fabricating personalized leads used for tape bonding and, bonding those leads to a particular chip. The ability to vary either the pattern cut from the metal tape on a real time basis for a particular chip or to personalize the bonding for the unique geometry of that chip is not found within the prior art germane to the manufacture of integrated circuit structures.

Computer controlled cutting systems, for example, in the manufacture of garments, are known where the cutting operation is in response to a stored program. For example, U.S. Patents 3,761,675 and 4,178,820 are directed to computer controlled techniques for cutting pattern pieces from computer generated markers. The '675 patent utilizes a laser cutting system wherein the cutting tool is under computer control having stored therein a program indicative of the particular marker. The pattern data is fed to the computer which then organizes the pieces within a sheet to minimize selvage. This orientation of the pieces, the market, is then stored and the outlines are utilized to control the cutter's trace. Similarly, the '820 patent utilizes a blade cutter operating under computer control to delineate the cutting path relative to the cutting table.

A hallmark characteristic of both of these systems is that the patterns which are cut define components of an overall apparel pattern. Those individual components following cuttings are separated from the selvage and are then individually assembled into the completed garment. Thus, while computer control is utilized for initial cutting of components, all fabrication steps following the actual cutting process are accomplished by hand. Other computerized cutting systems are found in U.S. Patents 3,490,320 and 3,764,775. Also, the particular marker is dedicated to one garment.

Thus, within the prior art, broadly pertinent to the concepts of cutting a required pattern from a strip of material within the art related to pattern cutting, once the components have in fact been produced from the strip they must then be assembled by hand. Within the technology specifically germane to the fabrication of semiconductor elements, there is no such personalization at either the cutting step or the bonding step. Rather, a repetition pattern is created in TAB techniques and repetitious bonding utilizing dedicated tools occurs at a subsequent station. Thus, to the extent that computer control techniques are utilized, they are inflexible and dedicated to a given footprint of the bonding conductors corresponding to a specific chip footprint.

In the above-mentioned US Patent 3,793,714 there is disclosed a method of interconnecting semiconductor devices, comprising the steps of:

—introducing to a bonding station a semiconductor chip having a plurality of terminals which form a particular footprint pattern on the chip surface,

—providing a selected pattern of metallic leads formed in a sheet of material as a personalized configuration matching the particular footprint of said semiconductor chip,

—aligning, in said bonding station, said lead pattern with said chip terminals,

—having, in said bonding station, a bonding tool operable under automatic control, and

—bonding each lead of said pattern to a corresponding terminal of said chip using said tool, thereby to form a chip/foil assembly.

Summary of the invention

Given the shortcomings of the prior art, it is an object of the present invention to define an improved method and apparatus for forming a semiconductor device wherein personalization occurs at both the step of pattern cutting and at the step of bonding.

Another object of the present invention is to utilize tape automated bonding materials in a personalized manner.

A still further object of the present invention is to provide a method and apparatus by which patterns personalized in a varying way to a variety of chips can be cut utilizing a single set of cutting tools and that bonding of such various patterns to the various individual chips can be accomplished forthwith utilizing a single set of bonding tools.

These and other objects of this invention, as claimed, are accomplished in a method of forming semiconductor devices wherein a continuous sheet of material suitable for forming leads is provided and continuously moved to a cutting station. The material may be an aluminum foil or any conventional tape automated bonding materials. A cutting tool, typically a laser, is provided at the cutting station. By computer control, the laser is guided to form a personalized footprint lead pattern for the chip to which it is to be bonded. Thus, the cutting of a preselected pattern in the strip occurs at the cutting station directly responsive to computer program control.

The strip then having the pattern cut therein is moved to a bonding station where it is aligned with the chip. A bonding tool is provided acting under computer control so that respective leads are affirmatively bonded sequentially to bumps provided on the chip and then, if required subsequently to a lead frame or a substrate. The bonded frame can be severed from the selvage. Thus, by this technique, computer controlled personalization of a pattern and bonding occur providing increased flexibility in the production system.

This invention will be described in greater detail by referring to the attached drawings and the description of the preferred embodiment that follows.

Brief description of the drawings

Fig. 1 is a diagram showing the basic system elements of the present invention;

Fig. 2 is a schematic perspective view showing an example of a laser personalized TAB tape, its placement over a chip, and a first bonding step;

Fig. 3A is a schematic perspective view showing the techniques of a second bonding step of a chip/foil assembly to a substrate;

Fig. 3B is a schematic perspective view showing an alternative second bonding step of a chip/foil assembly to a lead frame; and

Fig. 4 is a cross-section view showing an example of a clad metal tape which may be used in the practice of the present invention.

Description of the preferred embodiment

In accordance with both the prior art and the present invention, chips to be bonded utilizing TAB techniques have a plurality of bumps provided about the periphery of the active chip area. These bumps are elevated lands which are placed on the perimeter to accomplish the connection of the chip to the metal lead without fracturing passivation layers or creating short circuits in the chip.

Typically chip bumping is done by plating techniques. Such conventional bumps are shown, for example, in U.S. Patent 3,709,424 as contact pads 19 spaced on a semiconductor body.

While the present invention may utilize bumps formed by plating techniques, a significantly improved technique offers unique advantages. That is, by utilizing evaporative methods a metal bump may be formed under controlled conditions with extreme accuracy. For example, the bump may have a diameter in the range of 0.125 mm and an acceptable thickness in the range of 0.0175—0.375 mm. The metal selected for evaporation is for example 100 nm Cr with an aluminum bump.

In addition to the bumps which must be provided as the bonding surfaces on the chip, a second essential aspect of the present invention is the tape used for TAB. Within the prior art, conventional materials employ copper in combination with gold or tin coating and are attached to a substrate material, such as Mylar (TM) or a polyimide. The present invention while capable of utilizing those materials departs from the prior art by employing blank aluminum foil. The aluminum foil is not treated by etching although in high volume circumstances, such can be accomplished. It is known, however, that pre-etching to a given footprint constrains flexibility in the system and increases shelf life, storage and handling problems. In accordance with the present invention, the aluminum tape is cut by a laser from a blank roll of aluminum foil immediately prior to bonding. Hence, the cut foil is not stored and not subjected to off-line handling.

A third significant element in the practice of the present invention is the technique by which bonding occurs. Tape automated bonding generally utilizes a process wherein a thermal probe assembly is employed such that all bonding of inner leads occurs simultaneously. In contrast, wire bonding techniques proceed on a wire-by-wire basis as the probe feeds wire from a spool. Thus, in wire bonding techniques, the probe must move in a manner such that the inner bond, wire feed and wire dressing, and outer bond are done in a particular sequence. Thus, the probe must traverse the entire length of the wire for each wire so bonded. Typical lengths are in the range of 3—5 mm so that the bonding of each wire is a relatively time consuming step. In accordance with the present invention, ultrasonic bonding techniques are utilized wherein the personalized laser cut aluminum foil is suspended over and aligned to the chip bumps. Since no wire must be fed, a single probe accurately and rapidly steps from one lead end point to another lead end point, typically a distance of 0.2 mm. Thus, the rate at which ultrasonic bonding occurs utilizing a single tool is in the order of 5—10 times faster than wire bonding utilizing a single tool. While it is acknowledged that this bonding step is slower than the simultaneous TAB techniques, it is dependent on the I/O count. Nevertheless, a single tool may be used for an infinite variety of personalized wiring patterns.

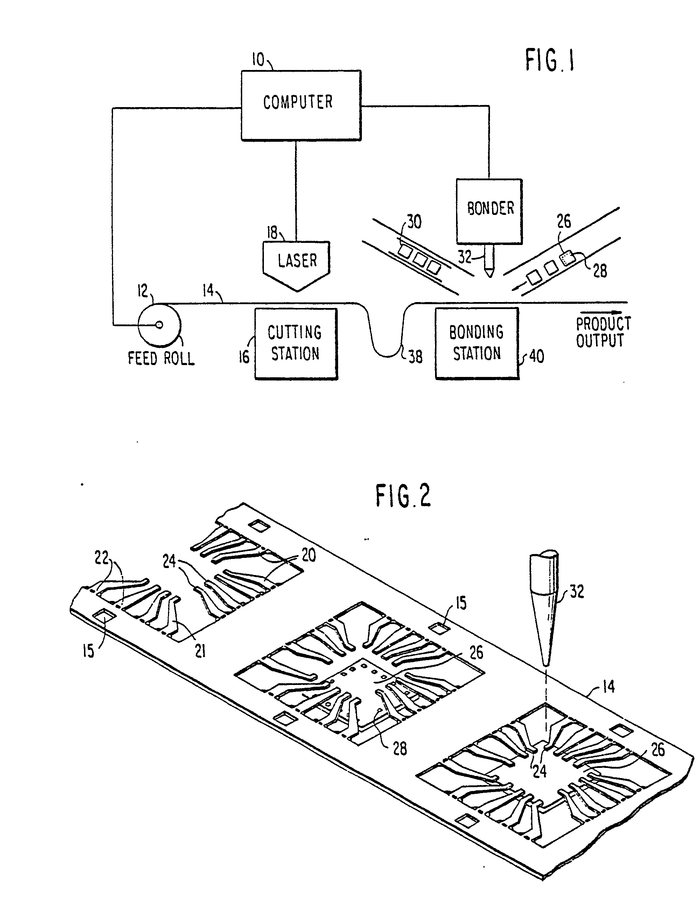

Referring now to Fig. 1, a schematic drawing of the system in accordance with the preferred embodiment of this invention is shown. The entire system is under the control of a computer 10 which monitors all system functions. The computer may be a general purposes multiprocessor, such as an IBM Series 1. The computer contains stored therein appropriate system programming to define both the personalization for the tape as well as the bonding sequence for a variety of lead and chip patterns. It will be appreciated by those versed in this technology that a variety of commercially available systems may be employed as suitable data processors.

A feed roll 12 contains a supply of aluminum foil stock. The aluminium foil 14 is fed in a conventional manner (sprocket, belt or roller drive or the like) to a cutting station 16 utilizing a laser cutter 18. At the cutting station, a laser is directed by two basic system commands from the computer 10. First, programmed signals for the finger positions of the leads as dictated by the chip footprint bond alignment requirement are inputted by an operator as a system input. Secondly, a set of programmed parameters or "ground rules" are stored to be used such as appropriate lead dimensions, spacings, termination points and the like. Thus, the laser 18 operating in conjunction with the downstream bonding station creates a personalized tape just prior to the bonding step. Buffer loop 38 is used to accommodate differences in cutting and bonding rates. While preferred, the loop is not required.

In accordance with the present invention, this personalized tape is created by laser cutting the blank tape 14 from the spool 12. Thus, for a particular chip footprint, an individual pattern is created. Registration is achieved in the case of roll stock by using sprockets and sprocket holes 15 on the marginal edges of the tape analogous to photographic film. It is apparent that individual sheets from a feed hopper can also be used.

In formation of the lead pattern, the foil may remain stationary while the laser scans the cutting table. Alternately, the foil can be indexed while the table and/or the laser operate in an X—Y cutting table sequence. Such techniques are well known in computerized cutting systems.

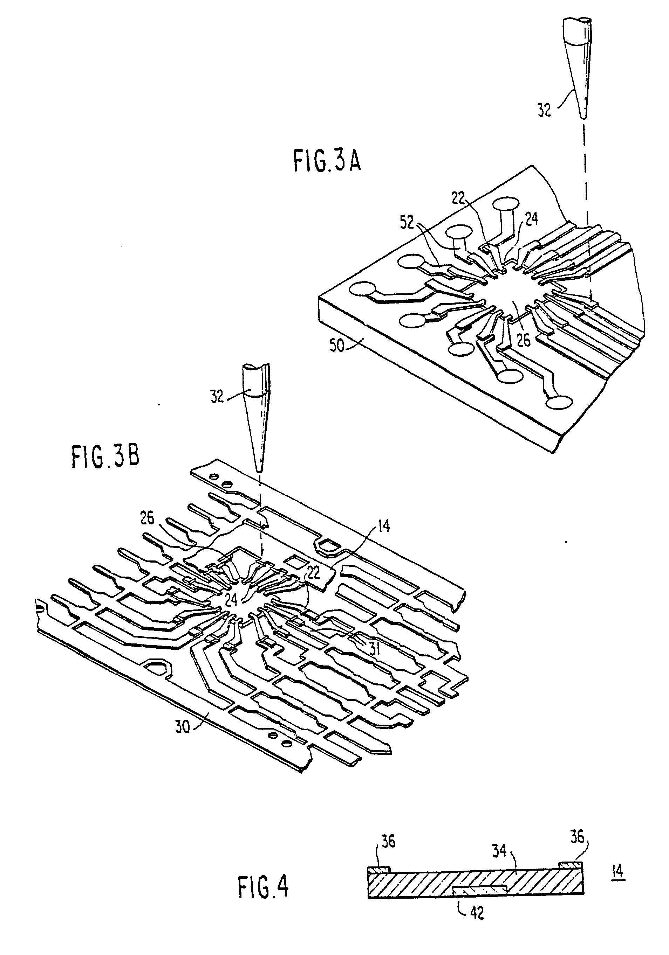

Referring now to Fig. 2, a perspective view of such a personalized tape is shown at the bonding station 40. It is understood that the personalization occurs while the tape remains on the selvage and it is subsequently separated after bonding to the chip or if required, after bonding to a substrate or lead frame occurs (Figs. 3A, 3B). Thus, as shown in Fig. 2, the personalized tape 14 arriving at the bonding station has a plurality of lead structures 20, formed therein. Each of the lead structures comprises a plurality of inwardly extending members formed from the conductive lead material. As shown in Fig. 2, the inwardly extending members 20 have intermediate zones 21 and tapered portions 24 which terminate in a spaced inner relationship in a contact area. Zone 22 is where selvage separation will occur. As shown, in this zone the inwardly extending members 20 have perforations to assist in separation.

A semiconductor body 26 (Fig. 2) has a series of bumps 28 as previously described. The inner tapered portions 24 are configured during personalization to be adapted to and aligned with the bumps 28. The semiconductor body is disposed under the foil 14.

Thus, when the tape 14 is fed to the bonding station 40, from the buffer loop 38, the personalized aluminum tape is aligned with a chip 26 which in turn is placed on a substrate 50 or lead frame 30. Fig. 1 illustrates the feeding of lead frames 30; substrates would be supplied in the same manner. With those three components aligned in the bonding station, as shown in Fig. 3, an ultrasonic probe 32 under control of the computer 10 steps sequentially from one lead end point 24 to another to perform ultrasonic welding of an individual bump 28 to an individual lead. This is a first bonding step.

In this manner, the automation advantages of TAB are attained, yet at the same time, the step spot ultrasonic welding technique is used via a generic tool not dedicated to any particular pattern. Given this operation, a bumped chip can be integrated in such a manner that low-volume TAB is accomplished in an economic manner commensurate with that of high-volume TAB techniques. The invention offers attendant advantages in that productivity over wire bonding techniques occurs with increased reliability.

Importantly, in accordance with the present invention, no planning or waiting is required to form a multitude of dedicated personalized tapes. The personalized tapes need not be handled or stored prior to utilization. Rather they are utilized forthwith in the subsequent manufacturing step.

As shown in Fig. 2, the ultrasonic probe 32 is stepped from lead to lead without having to traverse the full length of the wire as previously practiced in wire bonding techniques. Ultrasonic probe stepping has been demonstrated as being programmable on disc-type member system. Such techniques are known in conventional autobonding systems. By computer control, the same stored memory techniques are utilized such that the bump pattern on the chip is known and the probe is stepped from one bump to another to accomplish bonding in a systematic manner. While a single bonding head is illustrated, it is apparent that multiple heads may be used.

A second bonding step may also be employed at the bonding station. It may be either bonding the chip/foil assembly to a substrate (Fig. 3A) or, to a lead frame (Fig. 3B). In both cases the first bond fixes the terminal ends 24 to the chip bumps 28. Then, as shown in Fig. 3A the substrate 50 is placed under the chip/foil assembly. Portions 22 are bonded by probe 32 to pads 52 disposed on the substrate. Separation of the selvage may occur prior to or after this second bond. In a corresponding manner, bonding may be to a lead frame. As shown in Fig. 3B a lead frame 30 is placed under the chip/foil assembly. Bonding of the terminal portions 22 to leads 31 occurs. Substrates or lead frames are supplied to the bonding station in a conventional manner.

Following bonding, the product is released from the bonding station and the bonded assembly if required is then separated from the selvage. The selvage may then be recycled and the bonded chip assembly removed for subsequent processing. Alternatively, the bonded assembly may be rolled and stored intact without separation from the selvage.

While aluminum foil tape is a preferred material, other tapes may be used. For example, a clad metal tape may be used in a situation where it is desired to alternate the outer lead bond such as by soldering where copper, for example, would be preferable. This technique is applicable to a wide variety of substrate-lead frames and formats. Such a clad metal is shown in Fig. 4 and represents one of many available formats. This structure is applicable to gang solder reflow processes.

Fig. 4 illustrates in cross-section a clad metal tape 14 having an aluminum inlay 42 disposed at the finger area. This aluminum inlay is disposed in the area where ultrasonic bonding takes place. A copper base metal 34 is disposed at the outer bond area for solder bonding. Optionally, a solder strip 36 may be used along the outer edge of the tape.

The present invention therefore offers important advantages over conventional TAB or wire bonding techniques. It allows the integration of bumped chips utilizing personalized tape of aluminum or other adaptable clad structure cut from a blank metal. By utilizing a laser system, personalization on a computer controlled basis is immediately tailored to the bump configuration on the chip. Thus, the laser cutter is a generic tool which can be adapted under computer control to cut any desired pattern. Similarly, the step spot ultrasonic bonder is also a generic tool for accomplishing a step-by-step bonding more expeditiously than used in previous wire bonding techniques. The use of a single probe offers important economic advantages since the probe can be used to step-bond any personalized tape finger configuration under appropriate computer command.

It is apparent that modifications can be practiced. For example, using multiple heads in addition to processing one assembly, parallel bonding of different patterns can be accomplished under common computer control. Similarly multiple patterns may be cut in parallel from a width of foil using multiple laser cutters. Multiple cuts may also be made in stacked foils.

**Claims**

1. A method of interconnecting semiconductor devices, comprising the steps of:

introducing to a bonding station (40) a semiconductor chip (26) having a plurality of terminals (28) which form a particular footprint pattern on the chip surface,

providing a selected pattern (20) of metallic leads (21) formed in a sheet of material (14) as a personalized configuration matching the particular footprint of said semiconductor chip,

aligning, in said bonding station, said lead pattern (20) with said chip terminals (28),

having, in said bonding station, a bonding tool (32) operable under automatic control, and

bonding each lead (21) of said pattern (20) to a corresponding terminal (28) of said chip (26), using said tool thereby to form a chip/foil assembly,

characterized in that said step of providing a selected lead pattern (20) comprises:

providing in a cutting station (16), adjoined to said bonding station (40), a blank sheet (14) of a material suitable for forming into metallic leads,

having, in said cutting station, a steered cutting tool (18) operable under control of a computer (10) which also controls and steers the operations of said bonding tool (32),

cutting said selected personalized pattern (20) of metallic leads (21) in said sheet (14) using said cutting tool (18), and promptly transferring said personalized pattern (20) cut in said sheet (14) to said bonding station (40); whereby

various patterns (20) personalized to various respective semiconductor chips (26) can be sequentially created and bonded, tailored to the instantaneous supply of chips (26) to be bonded, and utilizing a single set of cutting and bonding tools.

2. The method of claim 1 further comprising the step of separating said pattern bonded to said semiconductor chip assembly from said sheet.

3. The method of claim 1 or 2, wherein the step of bonding further comprises the steps of placing said semiconductor chip and said pattern on a lead frame (30), positioning said lead frame into alignment with a terminal pattern (22) of said pattern (20) and, bonding said terminal pattern to leads (31) of said lead frame.

4. The method of claim 1 or 2, wherein the step of bonding further comprises the steps of placing a substrate (50) under said semiconductor chip and said pattern, positioning said substrate into alignment with a terminal pattern (22) of said pattern (20) and, bonding said terminal pattern to contacts (52) on said substrate.

5. The method of a previous claim, wherein said semiconductor chip (26) has a series of terminals (28), and the step of bonding comprises moving said bonding tool (32) from one terminal to another to consecutively bond said pattern to said terminals without tracing said pattern.

6. The method of a previous claim, wherein the step of cutting comprises moving said cutting tool (18) under computer control to trace a first pattern in said sheet that is personalized for a first semiconductor chip and subsequently moving said cutting tool under computer control to trace a second pattern in said sheet that is personalized for a second semiconductor chip.

7. The method of claim 6, wherein the step of bonding comprises moving said bonding tool under computer control to bond said first pattern to said first chip and subsequently moving said bonding tool under computer control to bond said second pattern to said second chip.

8. The method of a previous claim, wherein said cutting tool is a laser cutter.

9. The method of a previous claim, wherein said bonding tool is an ultrasonic probe.

10. The method of a previous claim, wherein said sheet material is aluminum foil.

11. The method of one of claims 1—9, wherein said sheet material is a clad foil (34) having a metal inlay (42) on one side for bonding to said chip and a terminal strip (36) on the opposite side thereof.

12. The method of a previous claim, wherein said sheet is supplied from a continuous roll (12) further comprising the optional step of segmenting said sheet prior to bonding said pattern to said chip.

13. The method of claim 1, further comprising the step of storing said semiconductor chip assembly on said sheet.

14. An apparatus for interconnecting various semiconductor devices under computer control, according to the method of a previous claim, characterized by:

a source (12) of blank sheet material (14) suitable for forming into conductive leads,

means to move said conductive sheet material (14) sequentially through a cutting station (16) and a bonding station (40),

a steered cutting tool (18) in said cutting station 16 under control of a computer (10) for cutting in said sheet (14) any selected lead pattern (20) personalized for a respective semiconductor chip (26) which is presented to said bonding station (40),

a steered bonding tool (32) in said bonding station (40) under control of said computer (10) for bonding said personalized lead pattern (20) in said sheet (14) to said respective semiconductor chip (26), whereby

various patterns may be personalized and bonded to various semiconductor chips, tailored to the supply of chips and using a single set of cutting and bonding tools.

15. The apparatus of claim 14 wherein said bonding station further comprises a supply of substrates (50), a substrate being placed under said pattern in said conductive material for bonding thereto.

16. The apparatus of claim 14 wherein said bonding station further comprises a supply of lead frames (30), a lead frame being placed under said pattern in said conductive material for bonding thereto.

**Patentansprüche**

1. Verfahren zum Verbinden von Halbleiterbauelementen, wobei:

—ein Halbleiterchip (26) mit einer Vielzahl von Anschlußstellen (28), die ein spezielles Fußabdruckmuster auf der Chipoberfläche bilden, in eine Bonderstation (40) geführt wird,

—ein ausgewähltes Muster (20) von metallischen Leitern (21) aus einem dünnen Material (14) geformt ist, welches mit seiner individuellen Konfiguration genau auf das spezielle Muster des Halbleiterchips paßt,

—in der Bonderstation das Muster (20) aus Metall-Leitern mit den Chipanschlüssen (28) ausgerichtet wird,

—in der Bonderstation ein Bonderwerkzeug (32) automatisch in Arbeit gesetzt wird, und

—wobei jeder Leiter (21) aus dem Muster (20) an einen entsprechenden Anschluß (28) des Chips (26) gebondet wird, wobei mit dem Werkzeug eine Chip/Folien-Verbindung hergestellt wird,

dadurch gekennzeichnet, daß die Vorgabe des Anschlußmusters (20) folgende Schritte umfaßt:

—in einer der Bonderstation (40); zugeordneten Schneidestation (16) ist eine unbearbeitete Folie (14) aus einem Material gegeben, welches für Metall-Leiter geeignet ist,

—die Schneidestation weist ein gesteuertes Schneidewerkzeug (18) auf, welches von einem Computer (10) gesteuert wird, der ebenfalls die Arbeit des Bonderwerkzeugs (32) steuert und regelt,

—das ausgewählte individuelle Muster (20) von Metall-Leitern (21) wird mit Hilfe des Schneidewerkzeugs (18) in die Folie (14) geschnitten, und

—das individuelle, in die Folie (14) geschnittene (Muster (20) wird umgehend zur Bonderstation (40) übertragen, wobei verschiedene Muster (20), die auf verschiedene, entsprechende Halbleiterchips (26) zugeschnitten worden sind, aufeinanderfolgend erzeugt und gebondet werden und auf die momentane Anzahl von zu bondenden Chips (26) abgestimmt werden, was mit einem einzigen Satz von Schneide- und Bonderwerkzeugen geschieht.

2. Verfahren nach Anspruch 1, dadurch gekennzeichnet, daß das auf die Halbleiterchipanordnung gebondete Muster von der Folie abgeschnitten wird.

3. Verfahren nach Anspruch 1 oder 2, dadurch gekennzeichnet, daß zusätzlich beim Bonden der Halbleiterchip und das Muster auf einen Rahmen (30) mit Leitern gesetzt werden, so daß der Rahmen mit Leitern mit den Anschlüßen (22) des Musters (20) ausgerichtet wird, und daß das Anschlußmuster an die Leitern (31) des Rahmens gebondet wird.

4. Verfahren nach Anspruch 1 oder 2, dadurch gekennzeichnet, daß zusätzlich beim Bonden ein Substrat (50) unter den Halbleiterchip und das Muster gebracht wird, daß das Substrat mit den Anschlüssen (22) des Musters (20) ausgerichtet wird und daß das Anschlußmuster an Kontakte (52) auf dem Substrat gebondet wird.

5. Verfahren nach einem der vorhergehenden Ansprüche, dadurch gekennzeichnet, daß der Halbleiterchip (26) eine Reihe von Anschlüssen (28) aufweist und daß beim Bonden das Bonderwerkzeug (32) von einem Anschluß zum nächsten bewegt wird, so daß das Muster fortlaufend an die Anschlüsse gebondet wird, ohne das Muster abzutasten.

6. Verfahren nach einem der vorhergehenden Ansprüche, dadurch gekennzeichnet, daß beim Schneiden das Schneidewerkzeug (18) unter Computersteuerung bewegt wird, so daß ein erstes Muster auf die Folie abgefahren wird, welches für einen ersten Halbleiterchip zugeschnitten worden ist und daß das Schneidewerkzeug unter Computersteuerung dann weiterbewegt und ein zweites Muster auf der Folie abgefahren wird, welches für einen zweiten Halbleiterchip zugeschnitten worden ist.

7. Verfahren nach Anspruch 6, dadurch gekennzeichnet, daß beim Bonden das Bonderwerkzeug unter Computersteuerung bewegt wird, so daß das erste Muster an den ersten Chip gebondet wird und dann das Bonderwerkzeug unter Computersteuerung weiterbewegt und ein zweites Muster an den zweiten Chip gebondet wird.

8. Verfahren nach einem der vorhergehenden Ansprüche, dadurch gekennzeichnet, daß das Schneidewerkzeug ein Laser-Schneider ist.

9. Verfahren nach einem der vorhergehenden Ansprüche, dadurch gekennzeichnet, daß das Bonderwerkzeug eine Ultraschallsonde ist.

10. Verfahren nach einem der vorhergehenden Ansprüche, dadurch gekennzeichnet, daß die Folie aus Aluminium ist.

11. Verfahren nach einem der Ansprüche 1—9, dadurch gekennzeichnet, daß die Folie eine geschichtete Folie (34) ist, die eine Metalleinlage (42) an einer Seite zum Bonden an den Chip und einen Anschlußstreifen (36) an der gegenüberliegenden Seite aufweist.

12. Verfahren nach einem der vorhergehenden Ansprüche, dadurch gekennzeichnet, daß die Folie von einer fortlaufenden Rolle (12) geliefert wird, wobei die Folie vor dem Bonden des Musters an den Chip segmentiert werden kann.

13. Verfahren nach Anspruch 1, dadurch gekennzeichnet, daß die Halbleiterchipanordnung auf der Folie gelagert werden kann.

14. Vorrichtung zum Verbinden verschiedener Halbleiterbauelemente unter Computersteuerung nach dem Verfahren nach einem der vorhergehenden Ansprüche, gekennzeichnet durch

—eine Quelle (12) für unbearbeitetes Folienmaterial (14), welches für Leiter geeignet ist,

—Einrichtungen zum fortlaufenden Bewegen des leitenden Folienmaterials (14) durch eine Schneidestation (16) sowie durch eine Bonderstation (40),

—ein gesteuertes Schneidewerkzeug (18) innerhalb der Schneidestation (16), welches unter der Steuerung eines Computers (10) jedes ausgewählte Muster (20) aus Metall-Leitern, welch für einen entsprechenden Halbleiterchip (26) zugeschnitten worden ist, welcher der Bonderstation (40) zugeführt wird, in die Folie (14) schneidet,

—ein gesteuertes Bonderwerkzeug (32) innerhalb der Bonderstation (40), welches unter der Steuerung des Computers (10) das zugeschnittene Anschlußmuster (20) innerhalb der Folie (14) an entsprechende Halbleiterchips (26) bondet, wobei verschiedene Muster zugeschnitten und an verschiedene Halbleiterchips gebondet werden können und auf das Chipangebot abgestimmt werden, was mit einem einzigen Satz von Schneide- und Bonderwerkzeugen geschieht.

15. Vorrichtung nach Anspruch 14, dadurch gekennzeichnet, daß der Bonderstation Substrate (50) zugeführt werden, wobei ein Substrat under das Muster in dem leitenden Material zum Anbondern gebracht wird.

16. Vorrichtung nach Anspruch 14, dadurch gekennzeichnet, daß der Bonderstation Rahmen (30) mit Leitern zugeführt werden, wobei ein Rahmen unter das Muster in dem leitenden Material zum Aufbondern gebracht wird.

**Revendications**

1. Procédé pour interconnecter des dispositifs semiconducteurs comprennent les étapes suivantes:

introduire sur un poste de connexion (40) une plaquette semiconductrice (26) possédant une pluralité de bornes (28) qui forment un dessin particulier d'encombrement sur la surface de la plaquette;

fournir un dessin déterminé (20) de conducteurs métalliques (21) formés dans un matériau en feuille (14) en tant que configuration personnalisée correspondant à l'encombrement particulier de ladite plaquette semiconductrice;

aligner, dans ledit poste de connexion, ledit dessin de conducteurs (20) avec lesdites bornes de plaquette (28);

prévoir, dans ledit pose de connexion, un outil de connexion (32) pouvant être actionné par commande automatique; et

connecter chaque conducteur (21) dudit dessin (20) à une borne correspondante (28) de ladite plaquette (26), à l'aide dudit outil pour constituer un assemblage plaquette-feuille;

caractérisé par le fait que ladite étape de fourniture d'un dessin déterminé de conducteurs (20) comprend:

fournir dans un poste de découpage (16) adjacent audit poste de connexion (40), un flan en feuille (14) d'un matériau pouvant être formé en conducteurs métalliques,

disposer, dans le dit poste de découpage, d'un outil de découpage guidé (18) pouvant fonctionner sous la commande d'un ordinateur (10) qui commande et guide également les opérations dudit outil de connexion (32),

découper ledit dessin personnalisé déterminé (20) de conducteurs métalliques (21) dans ladite feuille (14) à l'aide dudit outil de découpage (18) et

transférer sans délai, audit poste de connexion (40), ledit dessin personnalisé (20) découpé dans ladite feuille (14); grâce à quoi

divers dessins (20), personnalisés en fonction de diverses plaquettes semiconductrices (26) respectives, peuvent être successivement créés et connectés, tout en étant adaptés spécialement aux plaquettes (26) à connecter qui sont fournies à un instant donné, et en utilisant un jeu unique d'outils de découpage et de connexion.

2. Procédé selon la revendication 1, comprenant en outre l'étape consistant à séparer, de ladite feuille, ledit dessin connecté audit assemblage de plaquette semiconductrice.

3. Procédé selon la revendication 1 ou 2, dans lequel l'étape de connexion comprend en outre les étapes consistant à placer ladite plaquette semiconductrice et ledit dessin sur un cadre de conducteurs (30), positionner ledit cadre de conducteurs en alignment avec le dessin des bornes (22) dudti dessin (20) et connecter ledit dessin de bornes à des conducteurs (31) du cadre de conducteurs.

4. Procédé selon la revendication 1 ou 2, dans lequel l'étape de connexion comprend en outre les étapes consistant à placer un substrat (50) sous la dite plaquette semiconductrice et ledit dessin, positionner ledit substrat dans l'alignement d'un dessin de bornes (22) dudit dessin (20) et connecter ledit dessin de bornes à des contacts (52) dudit substrat.

5. Procédé selon l'une des revendications précédentes, dans lequel ladite plaquette semiconductrice (26) possède une série de bornes (28) et où l'étape de connexion comprend le fait de déplacer ledit outil de connexion (32) d'une borne à l'autre pour connecter successivement ledit dessin auxdites bornes sans tracer ledit dessin.

6. Procédé selon l'une des revendications précédentes, dans lequel l'étape de découpage comprend le fait de déplacer ledit outer de découpage (18) sous contrôle de l'ordinateur pour suivre un premier dessin dans ladite feuille, qui soit personnalisé pour une première plaquette semiconductrice et de déplacer ensuite ledit out de découpage sous contrôle de l'ordinateur pour suivre un second dessin dans ladite feuille, qui soit personnalisé pour une seconde plaquette semiconductrice.

7. Procédé selon la revendication 6, dans lequel l'étape de connexion comprend le fait de déplacer ledit outer de connexion sous contrôle de l'ordinateur pour connecter ledit premier dessin à ladite première plaquette et, ensuite, de déplacer ledit outil de connexion sous contrôle de l'ordinateur pour connecter ledit second dessin à ladite seconde plaquette.

8. Procédé selon l'une des revendications précédentes, dans lequel ledit outil de découpage est un découpeur à laser.

9. Procédé selon l'une des revendications précédentes, dans lequel ledit outil de connexion est une sonde ultrasonique.

10. Procédé selon l'une des revendications précédentes, dans lequel ledit matériau en feuille est de la feuille d'aluminium.

11. Procédé selon l'une des revendications 1 à 9, dans lequel ledit matériau en feuille est une feuille plaquée (34) comportant une inclusion métallique (42) d'un côté, pour connexion à ladite plaquette, et une barrette à bornes (36) du côté opposé.

12. Procédé selon l'une des revendications précédentes, dans lequel ladite feuille est délivrée par un rouleau continu (12), comprenant en outre l'étape facultative consistant à segmenter ladite feuille avant connexion dudit dessin à ladite plaquette.

13. Procédé selon la revendication 1, comprenant en outre l'étape consistant à stocker ledit assemblage de plaquette semiconductrice se trouvant sur ladite feuille.

14. Appareil pour interconnecter divers dispositifs semiconducteurs sous contrôle d'ordinateur, conformément au procédé de l'une des revendications précédentes, caractérisé par:

une source (12) de matériau sous forme de flan en feuille (14) pouvant être formé en conducteurs,

des moyens pour déplacer ledit matériau en feuille conducteur (14) successivement à travers un poste de découpage (16) et un poste de connexion (40),

un outil de découpage (18) dans ledit poste de découpage (16), guidé sous contrôle d'un ordinateur (10) pour découper dans ladite feuille (14) un dessin quelconque (20) de conducteurs déterminé, personnalisé pour une plaquette semiconductrice (26) correspondante qui est présentée audit poste de connexion (40),

un outil de connexion (32) dans ledit poste de connexion (40), guidé sous contrôle dudit ordinateur (10), pour connecter ledit dessin personnalisé de conducteurs (20) de ladite feuille (14) à ladite plaquette semiconductrice (26) correspondante, grâce à quoi

divers dessin peuvent être personnalisés et connectés à diverses plaquettes semiconductrices, adaptés spécialement aux plaquettes fournies et utilisant un jeu unique d'outils de découpage et de connexion.

15. Appareil selon la revendication 14, dans lequel ledit poste de connexion comprend en outre une provision de substrats (50), un substrat étant placé sous ledit dessin en matériau conducteur pour y être connecté.

16. Appareil selon la revendication 14, dans lequel ledit poste de connexion comprend en outre une provision de cadres de conducteurs (30), un cadre de conducteurs étant placé sous ledit dessin en matériau conducteur pour y être connecté.

0 130 498

FIG.1

COMPUTER

BONDER

LASER

CUTTING STATION

BONDING STATION

FEED ROLL

PRODUCT OUTPUT

FIG.2

1

FIG.3A

FIG.3B

FIG.4